Europäisches Patentamt

European Patent Office

Office européen des brevets

(11) Publication number: **0 055 129**
**B1**

(12) **EUROPEAN PATENT SPECIFICATION**

(45) Date of publication of patent specification: **16.05.90**

(51) Int. Cl.⁵: **G 11 C 29/00**

(21) Application number: **81306047.2**

(22) Date of filing: **22.12.81**

(54) Semiconductor memory device.

(30) Priority: **23.12.80 JP 182292/80**

(43) Date of publication of application:
**30.06.82 Bulletin 82/26**

(45) Publication of the grant of the patent:
**16.05.90 Bulletin 90/20**

(84) Designated Contracting States:
**DE FR GB NL**

(56) References cited:
**EP-A-0 034 070**
**FR-A-2 276 661**
**US-A-4 055 754**

**IEEE TRANSACTIONS ON COMPUTERS, vol.
C-27, no. 4, April 1978, pages 349-358, IEEE, New
York, US, V.P. SRINI: "Fault location in a
semiconductor random-access memory unit"**

(73) Proprietor: **FUJITSU LIMITED**
**1015, Kamikodanaka Nakahara-ku
Kawasaki-shi Kanagawa 211 (JP)**

(72) Inventor: **Tatematsu, Takeo**
**1550-2-33, Shimokurata-cho Totsuka-ku
Yokohama-shi Kanagawa 244 (JP)**

(74) Representative: **Fane, Christopher Robin King
et al
HASELTINE LAKE & CO. Hazlitt House 28
Southampton Buildings Chancery Lane
London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a semiconductor memory device in which a large number of memory cells are divided into blocks.

In recent years, available semiconductor memory devices have increased in capacity from 16 kbits, 64 kbits and 256 kbits to 1 Mbits. However, as the capacity of a semiconductor memory device increases, the time required for testing it also increases. For example, if the time for testing a 16 kRAM is 1, the time for testing a 64 kRAM is 4 and the time for testing a 256 kRAM is 8. In addition, the manufacturing yield of such memory devices is low and, accordingly, the number of defective devices is much larger than the number of good devices. Therefore, the time required for testing all the devices, including defective devices, is considerably large, which makes the manufacturing cost high.

In a large capacity semiconductor memory device, such as a 64 kRAM, a plurality of memory cells are divided into blocks of rows and columns, which allows decoders to be simple and small in electrical structure. In such devices, addresses are allocated commonly to each of the blocks. Therefore, the operation of selecting one memory cell within all of the memory cells is performed by selecting one memory cell within each of the blocks and by selecting one block within the blocks.

In the case of testing a semiconductor memory device in which a plurality of memory cells are divided into blocks, which testing is the same as that in a semiconductor memory device without having such blocks, definite test data, such as "1", is written into each of the memory cells. In this state, the test data stored in each of the memory cells is read out and it is checked as to whether or not the read-out data is "1". However, in this case, the read operation must be repeated by the number of memory cells and, in addition, the write operation must also be repeated by the number of memory cells. As a result, it takes a long time to test a semiconductor memory device in which memory cells are divided into blocks.

US—A—4,055,754 discloses a memory device having read test circuitry which reduces the time taken to test each memory cell by testing the cells a complete row at a time. The output of this prior art test circuitry is either a logic "1" if there is no fault in the row being tested, or a "0" if one or more faults exists in that row. This prior art, however, deals only with a conventional memory device, having its cells arranged in rows and columns with respective read/write data lines for all the columns. It does not concern itself with the particular configuration and problems of a large memory device in which each data bus must serve a complete block of cells arranged in rows and columns. Further, the read test circuitry output of this prior art can only provide the fault/no fault indication mentioned above.

It is an object of the present invention to provide a large scale memory device with read test circuitry capable of providing improved fault condition indicators.

According to the present invention, there is provided a semiconductor memory device including an array of memory cells arranged in rows and columns, which rows and columns are connected respectively with bit lines and word lines;

cell selection means for selecting memory cells so as to place them in connection with an input/output line for reading and writing data;

write circuitry for writing preselected data values into each of the selected memory cells; and

read test circuitry operable on the basis of a set of signals, received from memory cells selected for reading, to provide a fault-indicating response if the said set of signals differs from a predetermined desired set appropriate to desired normal operation of the device;

characterised in that the device comprises a plurality of such arrays, there being an individual pair of bit lines connected with each individual row of each array, and further includes a plurality of pairs of data buses which pairs are connected respectively to the memory cell arrays and provide respective such input/output lines, the cell selection means being operable to select a pair of bit lines from each memory array so as to place the selected bit lines in simultaneous connection with the respective corresponding data buses, thereby selecting one cell from each of the arrays;

and in that the read test circuitry comprises:

a first set of transistors equal in number to the pairs of data buses and having respective control electrodes connected individually to respective first data buses of those pairs;

a second set of transistors equal in number to the pairs of data buses and having respective control electrodes connected individually to respective second data buses of those pairs, the first and second sets of transistors being connected with output terminal means in such a manner that, after employing the write circuitry to write a preselected data value into every one of the selected memory cells, three different possible test output states can be produced, at the output terminal means, indicating respectively that:

i) the signals read from the selected cells are all the same, each representing the said preselected data value;

ii) the signal read from the selected cells are all the same, each representing a data value different from the said preselected data value;

iii) the signals read from the selected cells are not all the same.

Reference will now be made, by way of example, to the accompanying drawings, wherein:

Fig. 1 is a block diagram illustrating a semiconductor memory device having a read test circuit;

Fig. 2 is a detailed block diagram of the memory block 1—1 of Fig. 1;

Fig. 3 is a circuit diagram of the read test circuit of Fig. 1;

Fig. 4 is a circuit diagram of another read test circuit for an embodiment of the present invention;

Fig. 5 is a circuit diagram of a further read test circuit for an embodiment of the present invention;

Fig. 6 is a circuit diagram of yet another read test circuit for an embodiment of the present invention;

Fig. 7 is a circuit diagram of a block selection circuit 6 of Fig. 1;

Fig. 8 is a circuit diagram illustrating the principle of operation of part of a decoder $D_1$ for use in the block selection circuit of Fig. 7;

Fig. 9 is a circuit diagram of the decoder $D_1$ in the block selection circuit of Fig. 7.

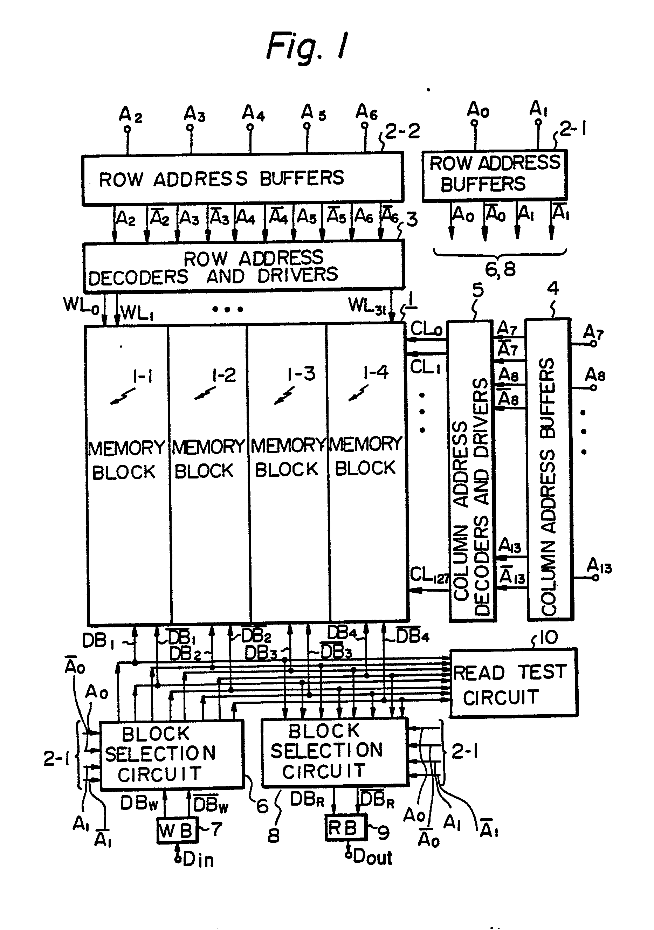

In Fig. 1, a main memory cell matrix 1 is divided into four memory blocks 1-1, 1-2, 1-3 and 1-4 each comprising $4096(=2^{12})$ bit memory cells; $A_0$ to $A_6$ are row address signals; and $A_7$ to $A_{13}$ are column address signals. In this case, one memory cell in each of the memory blocks 1-1, 1-2, 1-3 and 1-4 is selected by using the row address signals $A_2$ to $A_6$ and the column address signals $A_7$ to $A_{13}$ and, in addition, one memory block is selected by using the row address signals $A_0$ and $A_1$. In addition, 2-1 and 2-2 consist of row address buffers for converting a TTL level of the address signals $A_0$ to $A_6$ into a MOS level of address signals $A_0$ to $A_6$ and their inverted signals $\overline{A}_0$ to $\overline{A}_6$, and 3 consists of row address decoders and drivers for selecting one row memory cell array within each of the memory blocks 1-1, 1-2, 1-3 and 1-4. 4 consists of column address buffers for converting a TTL level of column address signals $A_7$ to $A_{13}$ into a MOS level of address signals $A_7$ to $A_{13}$ and their inverted signals $\overline{A}_7$ to $\overline{A}_{13}$ which are supplied to column address decoders and drivers 5 for selecting one column memory cell array within the main memory cell matrix 1.

$DB_1$, $\overline{DB}_1$; . . .; and $DB_4$, $\overline{DB}_4$ are pairs of data buses of the memory blocks 1-1, 1-2, 1-3 and 1-4 respectively. Normally during the write mode, one pair of the data buses $DB_1$, $\overline{DB}_1$ . . .; and $DB_4$, $\overline{DB}_4$ is selected by a block selection circuit 6, so that the selected pair of the data buses are connected to write data buses $DB_w$ and $\overline{DB}_w$, respectively, which pair is also connected to a write buffer 7 for receiving input data $D_{in}$. Similarly, during the read mode, one pair of the data buses $DB_1$, $\overline{DB}_1$; . . .; $DB_4$, $\overline{DB}_4$ is selected by a block selection circuit 8, so that the selected pair of the data buses are connected to the read data buses $DB_R$ and $\overline{DB}_R$, respectively, which are also connected to a read buffer 9 for generating output data $D_{out}$.

In the illustrated device, all of the data buses $DB_1$, $\overline{DB}_1$, . . ., $DB_4$ and $\overline{DB}_4$ are connected to a read test circuit 10 which enters into operation only during a read test mode.

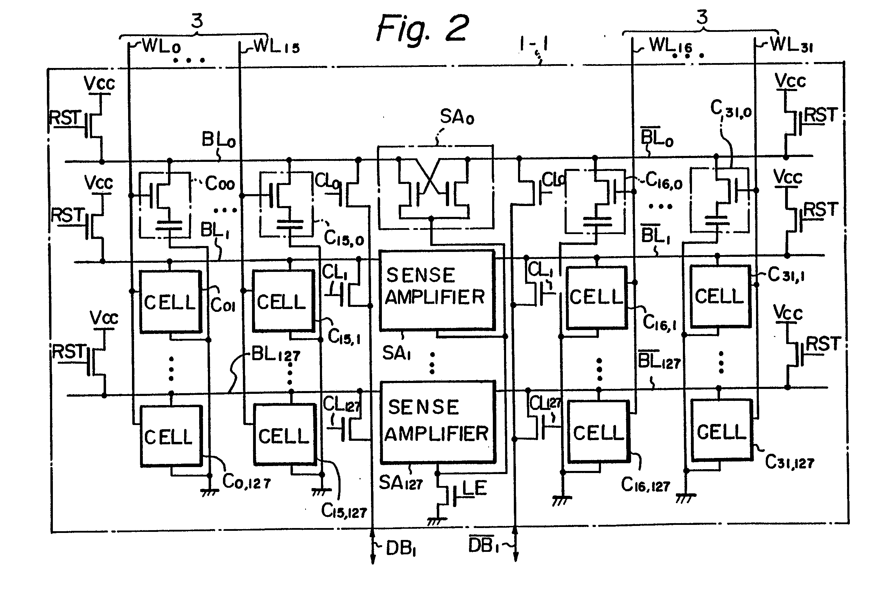

Fig. 2 is a detailed block diagram of the memory block 1-1 of Fig. 1. Note that the circuits of the other memory blocks 1-2, 1-3 and 1-4 are the same as the circuit of the memory block 1-1. In Fig. 2, $SA_0$, $SA_1$, . . ., $SA_{127}$ are sense amplifiers each connected to pairs of bit lines $BL_0$, $\overline{BL}_0$; $BL_1$, $\overline{BL}_1$; . . .; $BL_{127}$, $\overline{BL}_{127}$. The sense amplifiers $SA_0$, $SA_1$, . . ., $SA_{127}$ are activated commonly by a latch enable signal LE. RST is a reset signal for precharging the bit lines $BL_0$, $\overline{BL}_0$, $BL_1$, $\overline{BL}_1$, . . ., $BL_{127}$, $\overline{BL}_{127}$ during a stand-by mode. At intersections occurring between the word lines $WL_0$, . . ., $WL_{15}$, $WL_{16}$, . . ., $WL_{31}$ and the bit lines $BL_0$, $\overline{BL}_0$, $BL_1$, $\overline{BL}_1$, . . ., $BL_{127}$, $\overline{BL}_{127}$, memory cells $C_{00}$, . . ., $C_{15,0}$, $C_{16,0}$, . . ., $C_{31,0}$, . . ., $C_{31,127}$ which are, for example, of a one-transistor and one-capacitor type, are provided. In addition, $CL_0$, $CL_1$, . . ., $CL_{127}$ are column selection signals for selecting a bit line pair and connecting the selected bit line pair to the pair of data buses $DB_1$ and $\overline{DB}_1$.

The operation of the circuit of Fig. 2 will be briefly explained. First, during the stand-by mode (or precharge mode), the potential of the signal RST is caused to be high so as to precharge all of the bit lines $BL_0$, $\overline{BL}_0$, $BL_1$, $\overline{BL}_1$, . . ., $BL_{127}$, $\overline{BL}_{127}$. Next, after the potential of the signal RST falls, during a row selection mode, the potential of only one of the word lines $WL_0$, . . ., $WL_{15}$, $WL_{16}$, . . ., $WL_{31}$ is caused to be high, so as to select one memory cell within each pair of the bit line pairs. Next, during a sensing mode, the potential of the signal LE is caused to be high so as to activate all of the sense amplifiers $SA_6$, $SA_1$, . . ., $SA_{127}$. Next, during a column selection mode, the potential of only one of the column selection signals $CL_0$, $CL_1$, . . ., $CL_{127}$ is caused to be high, so that the potential of each bit line of the selected pair is transmitted to the data buses $DB_1$ and $\overline{DB}_1$, respectively. Therefore, the data stored in the selected memory cell is determined by the difference in potential between the data buses $DB_1$ and $\overline{DB}_1$.

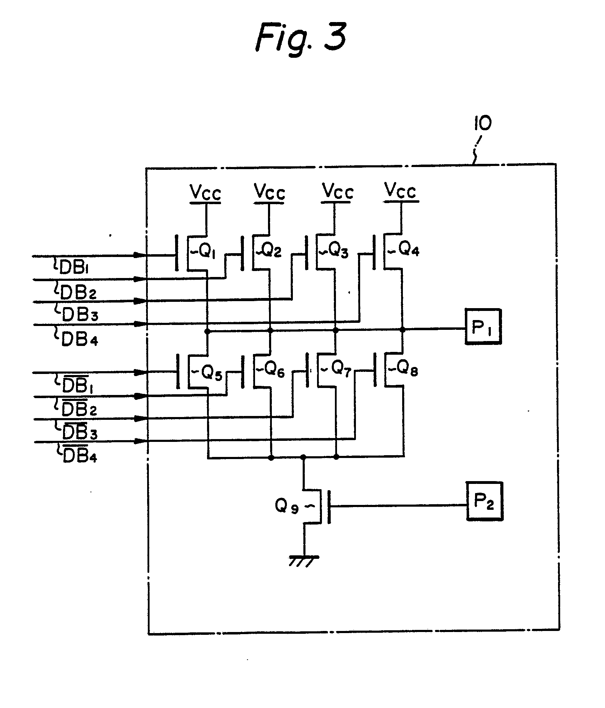

Fig. 3 is a circuit diagram of the read test circuit 10 of Fig. 1. In Fig. 3, $Q_1$ to $Q_4$ are MOS transistors each having a gate connected to one of the positive data buses $DB_1$ through $DB_4$, while $Q_5$ to $Q_8$ are MOS transistors each having a gate connected to one of the negative data buses $\overline{DB}_1$ through $\overline{DB}_4$. The transistors $Q_1$ to $Q_4$ are connected in series to the transistors $Q_5$ to $Q_8$, respectively, and in addition, the connection point of such transistors is connected to a common pad $P_1$ which serves as an output terminal.

$Q_9$ is a MOS transistor for activating the read test circuit 10 when the potential at a pad $P_2$ is high. In addition, note that the read test circuit 10 is provided between two power supply terminals whose potentials are $V_{cc}$ and the ground, respectively.

As illustrated in Fig. 3, each circuit formed by the transistors $Q_1$ and $Q_5$, the transistors $Q_2$ and $Q_6$, the transistors $Q_3$ and $Q_7$, and the transistors $Q_4$ and $Q_8$ is a kind of push-pull circuit.

The read test operation of the device of Figs. 1 and 2 by the read test circuit 10 of Fig. 3 will now be explained. Usually, during a test mode, the same data is written into a memory cell of each of the memory blocks 1-1, 1-2, 1-3 and 1-4 to which the same address is allocated. Now consider that the data "1" is written into the memory cell $C_{00}$ of each of the memory blocks 1-1, 1-2, 1-3 and 1-4. When this data stored in the memory cell $C_{00}$ is read out, the potential of each of the data buses $DB_1$ to $DB_4$ is, for example, high, and the potential of each of the data buses $\overline{DB_1}$ to $\overline{DB_4}$ is low. As a result, the transistors $Q_1$ to $Q_4$ are turned on, while the transistors $Q_5$ to $Q_8$ are turned off. Note that, in this case, all the transistors are of an n-channel type. Therefore, the potential at the pad $P_1$ becomes high and equals $V_{cc}$. Similarly, now consider that the data "0" is written in the memory cell $C_{01}$ of each of the memory blocks 1-1, 1-2, 1-3 and 1-4. When this data stored in the memory cell $C_{01}$ is read out, the potential of each of the data buses $DB_1$ to $DB_4$ is low, while the potential of each of the data buses $\overline{DB_1}$ to $\overline{DB_4}$ is high. As a result, the transistors $Q_1$ to $Q_4$ are turned off, while the transistors $Q_5$ to $Q_8$ are turned on. Therefore, the potential at the pad $P_1$ becomes low and equals the ground level.

Contrary to the above, when the data "0" is written into the cell $C_{00}$ of the memory block 1-1, in spite of desiring to write the data "1" thereinto, the transistor $Q_1$ is turned off and the transistors $Q_2$, $Q_3$ and $Q_4$ are turned on. In addition, the transistor $Q_5$ is turned on and the transistors $Q_6$, $Q_7$ and $Q_8$ are turned off. As a result, the potential at the pad $P_1$ becomes

$$V_{cc} \times \frac{R_{on2}}{R_{on1} + R_{on2}}$$

where $R_{on1}$ is an equivalent resistance of the on-state transistors $Q_2$, $Q_3$ and $Q_4$ and $R_{on2}$ is an equivalent resistance of the on-state transistor $Q_5$. Similarly, when the data "1" is written into the cell $C_{01}$ of the memory block 1-1, in spite of desiring to write the data "0" thereinto, the transistor $Q_1$ is turned on and the transistors $Q_2$, $Q_3$ and $Q_4$ are turned off. In addition, the transistor $Q_5$ is turned off and the transistor $Q_6$, $Q_7$ and $Q_8$ are turned on. As a result, the potential at the pad $P_1$ becomes

$$V_{cc} \times \frac{R_{on2}'}{R_{on1}' + R_{on2}'}$$

where $R_{on1}'$ is an equivalent resistance of the on-state transistor $Q_1$ and $R_{on2}'$ is an equivalent resistance of the on-state transistors $Q_6$, $Q_7$ and $Q_8$.

In summary, if the same data "1" or "0" is normally written into memory cells to which the same address is allocated, the potential at the pad $P_1$ equals $V_{cc}$ or the ground level. Contrary to this, if undesired data is written into at least one memory cell, the potential at the pad $P_1$ equals an intermediate value between the ground level and $V_{cc}$ determined by the equivalent resistances of the on-state transistors. Therefore, by checking the potential at the pad $P_1$ of Fig. 3, determining whether the device of Fig. 1 is normal or abnormal can be easily accomplished four times faster, as compared with the case where the potential at the outputs of the block selection circuit 8 are checked.

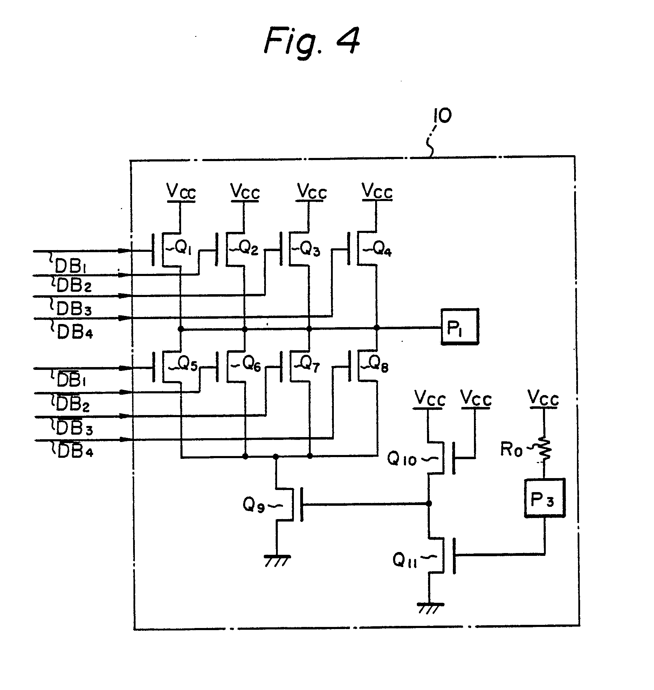

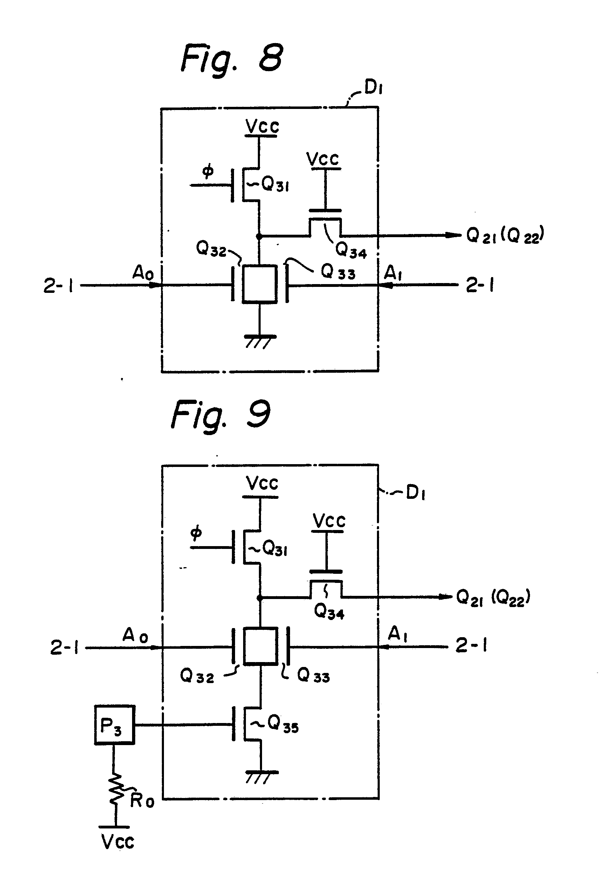

In Fig. 4, an inverter, formed by transistors $Q_{10}$ and $Q_{11}$ connected together in series, and a resistor $R_0$ are added to the circuitry of Fig. 3. In Fig. 4, when the potential at the pad $P_3$ is low, the potential at the gate of the transistor $Q_9$ is high, so as to render the transistor $Q_9$ conductive. In this state, the operation of the circuit of Fig. 4 is the same as that of the circuit of Fig. 3. However, as will be explained later with reference to Fig. 9, the pad $P_3$ of Fig. 4 may be used commonly for decoders of the block selection circuit 6 (Fig. 1), which is helpful in decreasing the number of pads.

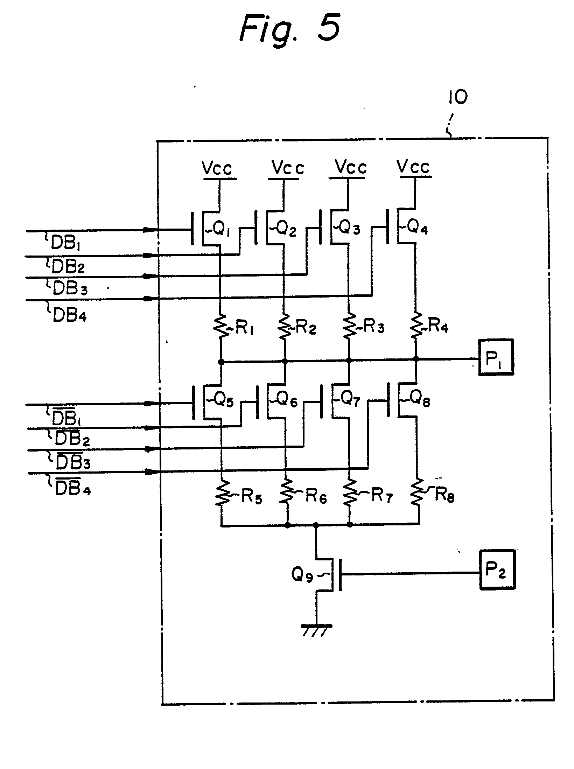

In Fig. 5, resistors $R_1$ to $R_8$ are connected in series with the transistors $Q_1$ to $Q_8$ (Fig. 3), respectively. In this case, the value of each of the resistors $R_1$ to $R_8$ is much larger than each of the equivalent resistances of the on-state transistors $Q_1$ to $Q_8$. As a result, in the same way as in Fig. 3, when undesired data is written into a memory cell, the potential at the pad $P_1$ becomes an intermediate value between the ground level and $V_{cc}$. However, this intermediate value is determined by the values of the resistors connected to the on-state transistors, not by the resistances of the on-state transistors which are unstable. Therefore, in Fig. 5, such an intermediate value is determined precisely by the values of the resistors $R_1$ to $R_8$.

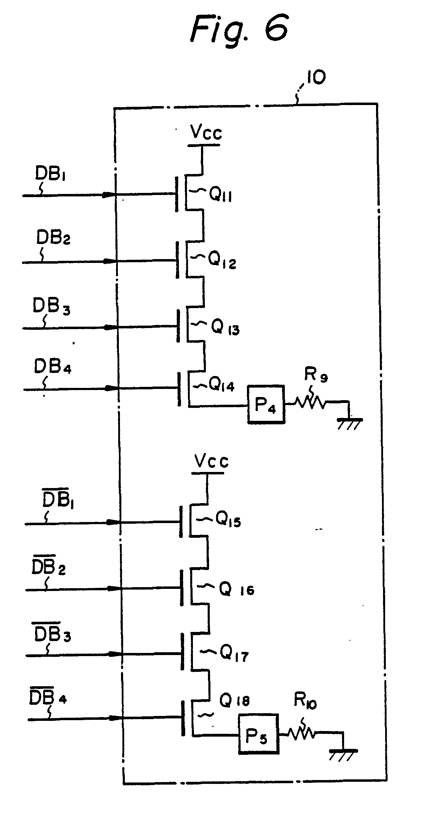

Fig. 6 is still another modification of Fig. 3. In Fig. 6, transistors $Q_{11}$ to $Q_{14}$, each having a gate connected to one of the positive data buses $DB_1$ to $DB_4$, are connected in series. One terminal of this series circuit is connected to the first power supply terminal ($V_{cc}$), while the other terminal is connected via a pad $P_4$ and a resistor $R_9$ to the second power supply terminal (the ground). Similarly, transistors $Q_{15}$ to $Q_{18}$, each having a gate connected to one of the negative data buses $\overline{DB_1}$ to $\overline{DB_4}$, are connected in series. One terminal of this series circuit is connected to the first power supply terminal ($V_{cc}$), while the other terminal is connected via a pad $P_5$ and a resistor $R_{10}$ to the second power supply terminal (the ground level).

In Fig. 6, when the same data is normally written into each of the memory cells to which the same address is allocated, the potential at one of the pads, $P_4$ or $P_5$, becomes high and equals $V_{cc}$ and the potential at the other pad becomes low and equals the ground level. Now consider that the data "1" is written into the memory cell $C_{00}$ (Fig. 2) of each of the memory blocks 1-1, 1-2, 1-3 and 1-4. When this data is read out, the potential of each of the data buses $DB_1$ to $DB_4$ is high, and the potential of each of the data buses $\overline{DB_1}$ to $\overline{DB_4}$ is low. As a result, the transistors $Q_{11}$ to $Q_{14}$ are turned on, so that the potential at the pad $P_4$ equals $V_{cc}$. In addition, the transistors $Q_{15}$ to $Q_{18}$ are turned off, so that the potential at the pad $P_5$ equals the ground level. Similarly, when the same data "0" is normally written into the memory cell

$C_{01}$ (Fig. 2) of each of the memory blocks 1-1, 1-2, 1-3 and 1-4 (Fig. 1), the potential at the pad $P_4$ equals the ground level and the potential at the pad $P_5$ equals $V_{cc}$.

Contrary to the above, when the data "0" is written into the memory cell $C_{00}$ (Fig. 2) of the memory block 1-1 (Fig. 1), in spite of desiring to write the data "1" thereinto, the transistor $Q_{11}$ is turned off and the transistors $Q_{16}$, $Q_{17}$ and $Q_{18}$ are also turned off. As a result, the potentials at the pads $P_4$ and $P_5$ both become low and equal the ground level. Similarly, when the data "1" is written into the memory cell $C_{01}$ (Fig. 2) of the memory block 1-1 (Fig. 1), in spite of desiring to write the data "0" thereinto, the transistors $Q_{12}$, $Q_{13}$ and $Q_{14}$ are turned off and the transistor $Q_{15}$ is also turned off. As a result, also in this case, the potentials at the pads $P_4$ and $P_5$ both become low and equal the ground level.

In summary, if the same data "1" or "0" is normally written into memory cells to which the same address is allocated, the potential at one pad becomes $V_{cc}$ and the potential at the other pad becomes the ground level. Contrary to this, if undesired data is written into at least one memory cell, the potentials at the pads $P_4$ and $P_5$ both become the ground level. Therefore, by checking the potentials at the pads $P_4$ and $P_5$ of Fig. 6, it can be determined whether the device of Fig. 1 is normal or abnormal.

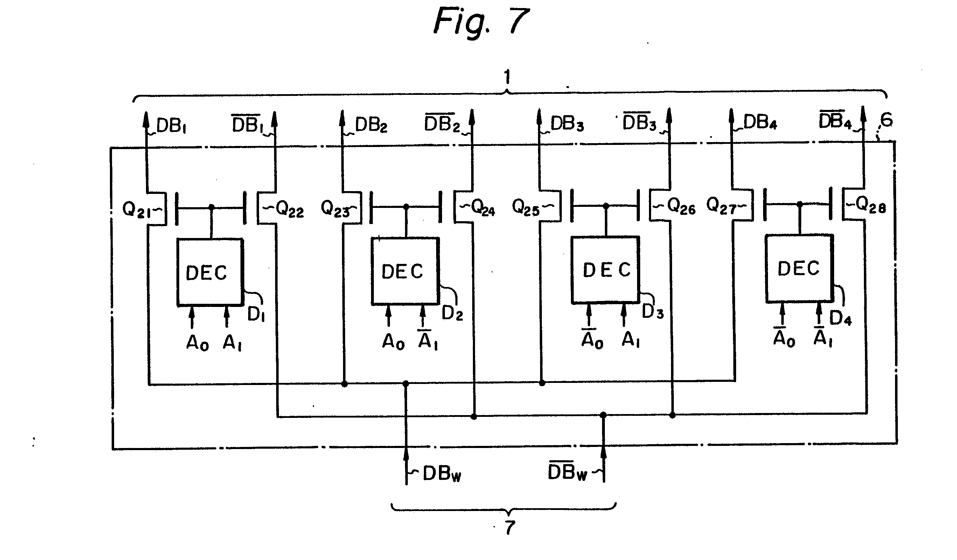

Fig. 7 is a circuit diagram of the block selection circuit 6 of Fig. 1. A plurality of transfer gate transistors $Q_{21}$, $Q_{22}$, ..., $Q_{28}$ are provided in order to selectively connect the data buses $DB_1$, $\overline{DB_1}$, ..., $DB_4$, $\overline{DB_4}$ to the data buses $DB_w$ and $\overline{DB_w}$ which are connected to the write buffer 7. The transfer gate transistors $Q_{21}$, $Q_{22}$, ..., $Q_{28}$ are controlled by decoders $D_1$, $D_2$, $D_3$ and $D_4$. Circuitry of this type is known per se from FR—A—2 276 661. The operation of decoders $D_1$ to $D_4$ will now be explained with reference to Fig. 8.

Fig. 8 is a schematic circuit diagram of part of the decoder $D_1$ of Fig. 7. Note that the circuits of the other decoders $D_2$, $D_3$ and $D_4$ are the same as that of the decoder $D_1$. In Fig. 8, $Q_{31}$ is a transistor for activating the decoder of Fig. 7 when the potential of a clock signal $\phi$ is high; $Q_{32}$ and $Q_{33}$ are transistors for receiving the address signals $A_0$ and $A_1$ from the row address buffers 2-1 (Fig. 1); and $Q_{34}$ is a transfer gate transistor. In this decoder $D_1$, only when the potentials of the address signals $A_0$ and $A_1$ are both low and the potential of the clock signal $\phi$ is high, can the transistor $Q_{34}$ transmit a high potential signal.

Therefore, in Fig. 7, only one of the decoders $D_1$, $D_2$, $D_3$ and $D_4$ transmits such a high potential signal in accordance with a combination of the address signals $A_0$ and $A_1$, so as to select one of the blocks 1-1, 1-2, 1-3 and 1-4 of Fig. 1.

In Fig. 9, a transistor $Q_{35}$, a pad $P_3$ and a resistor $R_0$, which serve as a simultaneous write means, are added to the circuitry of Fig. 8. Note that the pad $P_3$ and the resistor $R_0$, which are the same as in Fig. 4, are common to the other decoders $D_2$, $D_3$ and $D_4$ of Fig. 7.

During the normal mode, the potential at the pad $P_3$ is high, since no probe is placed on the pad $P_3$. As a result, the transistor $Q_{35}$ is turned on. Therefore, in this state, the operation of the circuit of Fig. 9 is as described in relation to Fig. 8.

Contrary to the above, during a write mode for writing test data, the potential at the pad $P_3$ is caused to be low, so as to turn off the transistor $Q_{35}$, regardless of the state of the transistors $Q_{32}$ and $Q_{33}$; that is, regardless of the address signals $A_0$ and $A_1$. Therefore, in Fig. 7, all of the transistors $Q_{21}$ through $Q_{28}$ are turned on, so that all the blocks 1-1, 1-2, 1-3 and 1-4 (Fig. 1) are selected. Therefore, in Fig. 1, input data $D_{in}$ supplied to the write buffer WB is written simultaneously into memory cells to which the same address is allocated. Thus, the write operation for writing test data by the block selection circuit 6, including the decoders as illustrated in Fig. 9, can be performed four-times faster, as compared with a case where the block selection circuit 6 comprises decoder circuitry merely as illustrated in Fig. 8.

In the above-mentioned embodiment, the test circuit 10 is connected to all the data buses $DB_1$, $\overline{DB_1}$, ..., $\overline{DB_4}$, so that the stray capacity of each of the data buses is increased. However, since only one gate of a MOS transistor is connected to each of the data buses, such increase of the stray capacity can be neglected. In addition, in the above-mentioned embodiment, a semiconductor memory device, including memory cells of a dynamic type, is illustrated; however, the present invention can be applied to a semiconductor memory device of a static type.

**Claims**

1. A semiconductor memory device including an array of (1-1, ... 1-4) of memory cells ($C0_0$, $C0_1$, ... $C31_{,127}$) arranged in rows and columns, which rows and columns are connected respectively with bit lines ($BC_0$, $BC_1$, ...) and word lines (W0, $WL_1$, ...);

cell selection means (2, 3, 4, 5) for selecting memory cells so as to place them in connection with an input/output line for reading and writing data;

write circuitry (6, 7) for writing preselected data values ("0", "1") into each of the selected memory cells; and

read test circuitry (10) operable on the basis of a set of signals, received from memory cells selected for reading, to provide a fault-indicating response if the said set of signals differs from a predetermined desired set appropriate to desired normal operation of the device;

characterised in that the device comprises a plurality of such arrays, there being an individual pair of bit lines connected with each individual row of each array, and further includes a plurality of pairs of data buses ($DB_1$, $\overline{DB_1}$, ... $DB_4$, $\overline{DB_4}$) which pairs are connected respectively to the memory cell arrays and provide respective such input/ output lines, the cell selection means being operable to select a pair of bit lines from each memory array so as to place the selected bit lines in simultaneous connection with the respective corresponding data buses, thereby selecting one cell from each of the arrays;

and in that the read test circuitry comprises:

a first set of transistors ($Q_1$—$Q_4$; $Q_{11}$—$Q_{14}$) equal in number to the pairs of data buses and having respective control electrodes connected individually to respective first data buses ($DB_1$—$DB_4$) of those pairs;

a second set of transistors ($Q_5$—$Q_8$; $Q_{15}$—$Q_{18}$) equal in number to the pairs of data buses and having respective control electrodes connected individually to respective second data buses ($DB_1$—$DB_4$) of those pairs, the first and second sets of transistors being connected with output terminal means in such a manner that, after employing the write circuitry to write a preselected data value ("0" or "1") into every one of the selected memory cells, three different possible test output states can be produced, at the output terminal means, indicating respectively that:

i) the signals read from the selected cells are all the same, each representing the said preselected data value;

ii) the signals read from the selected cells are all the same, each representing a data value different from the said preselected data value;

iii) the signals read from the selected cells are not all the same.

2. A device as claimed in claim 1, wherein the transistors of the first set ($Q_1$—$Q_4$) are connected in parallel between a first power supply line ($V_{cc}$) and an output point ($P_1$), and the transistors ($Q_5$—$Q_8$) of the second set are connected in parallel between the said output point ($P_1$) and a further circuit point, said output point ($P_1$) serving as the output terminal means.

3. A device as claimed in claim 2, in which the read test circuitry (10) comprises a third transistor ($Q_9$) connected between the said further circuit point and a second power supply line and having a control electrode the potential of which is switched from a first value, such as to render the third transistor non-conductive, to a second value, such as to render the third transistor conductive, when the read test circuitry (10) is to be rendered operative.

4. A device as claimed in claim 2 or 3, wherein the said read test circuitry (10) further comprises a plurality of resistors ($R_1$ to $R_8$) connected in series individually with respective transistors of the first and second sets ($Q_1$—$Q_8$).

5. A device as claimed in claim 1, wherein the transistors of the first set are connected in series between a first supply line ($V_{cc}$) and a first output point ($P_4$), and the transistors ($Q_{15}$—$Q_{18}$) of the second set are connected in series between the said first power supply line ($V_{cc}$) and a second output point ($P_5$), the read test circuitry (10) further comprising first and second resistors ($R_9$, $R_{10}$), the first and second output points ($P_4$, $P_5$) being connected to a second power supply line by way of the said first and second resistors respectively and serving as said output terminal means.

6. A device as claimed in any preceding claim wherein the write circuitry (6, 7) includes block selection circuitry (6) which comprises a plurality of transfer gate transistors ($Q_{21}$, $Q_{22}$; to $Q_{27}$, $Q_{28}$), connected individually to the respective data bus pairs ($DB_1$, $\overline{DB_1}$; to $DB_4$ $\overline{DB_4}$) for receiving input data and transferring the said input data to the said data bus pairs;

a plurality of decoders ($D_1$—$D_4$), connected individually to the respective pairs of transfer gate transistors ($Q_{21}$, $Q_{22}$; to $Q_{27}$, $Q_{28}$) at respective control electrodes thereof, for selecting one of the said data bus pairs ($DB_1$, $\overline{DB_1}$; to $DB_4$, $\overline{DB_4}$);

simultaneous-write means ($Q_{35}$, $R_0$, $P_3$), connected to each of the said decoders ($D_1$—$D_4$), operable to cause all the said data bus pairs to be selected simultaneously so as to permit the said input data to be written simultaneously into all of the memory cells selected by the said cell selection means (2, 3, 4, 5).

## Patentansprüche

1. Halbleiterspeichervorrichtung mit einer Anordnung von (1-1, . . . 1-4) von Speicherzellen ($C0_0$, $C0_1$, . . . $C_{31,127}$), die in Reihen und Spalten angeordnet sind, welche Reihen und Spalten jeweils mit Bitleitungen ($BC_0$, $BC_1$, . . .) beziehungsweise Wortleitungen (W0, $WL_1$, . . .) verbunden sind;

Zellenauswahleinrichtungen (2, 3, 4, 5) zum Auswählen von Speicherzellen, um sie so mit einer Eingangs/Ausgangs-Leitung zum Lesen und Schreiben von Daten in Verbindung zu bringen;

einer Schreibschaltung (6, 7) zum Schreiben vorausgewählter Datenwerte ("0", "1"), in jede der ausgewählten Speicherzellen; und

einer Lesetestschaltung (10), die auf der Basis eines Satzes von Signalen betreibbar ist, die von Speicherzellen empfangen werden, welche zum Lesen ausgewählt wurden, um eine Fehleranzeigeantwort zu liefern, falls der genannte Satz von Signalen von einem vorbestimmten, gewünschten Satz differiert, welcher für den gewünschten normalen Betrieb der Vorrichtung geeignet ist;

dadurch gekennzeichnet, daß die Vorrichtung eine Vielzahl solcher Anordnungen umfaßt, daß es ein individuelles Paar von Bitleitungen gibt, die mit jeder individuellen Reihe von jeder Anordnung verbunden sind, und daß sie ferner eine Vielzahl von Paaren von Datenbussen ($DB_1$, $\overline{DB_1}$, . . . $DB_4$, $\overline{DB_4}$) umfaßt, welche Paare jeweils mit den Speicherzellenanordnungen verbunden sind und jeweils solche Eingangs/Ausgangsleitungen bilden, wobei die Zellenauswahleinrichtungen betreibbar sind, um ein Paar von Bitleitungen von jeder Speicheranordnung auszuwählen, um so die ausgewählten Bitleitungen in gleichzeitige Verbindung mit den jeweils entsprechenden Datenbussen zu bringen, wodurch eine der Zellen von jeder der Zellenanordnungen ausgewählt wird;

und daß die Lesetestschaltung umfaßt:

einen ersten Satz von Transistoren ($Q_1$—$Q_4$; $Q_{11}$—$Q_{14}$), in gleicher Anzahl wie die Paare von Datenbussen, und jeweils mit Steuerelektroden, die individuell mit jeweils ersten Datenbussen (DB$_1$—DB$_4$) von jenen Paaren verbunden sind;

einen zweiten Satz von Transistoren (Q$_5$—Q$_8$; Q$_{15}$—Q$_{18}$), von gleicher Zahl wie die Paare von Datenbussen, und jeweils mit Steuerelektroden, die individuell mit jeweils zweiten Datenbussen (DB$_1$—DB$_4$) von jenen Paaren verbunden sind, wobei die ersten und zweiten Sätze von Transistoren mit Ausgangsanschlußeinrichtungen in solch einer Weise verbunden sind, daß, nach Verwendung der Schreibschaltung zum Schreiben vorausgewählter Datenwerte ("0" oder "1") in jede einzelne der ausgewählten Speicherzellen, drei verschiedene mögliche Testausgangszustände an jeder Ausgangsanschlußeinrichtung erzeugt werden können, welche anzeigen, daß:

i) die von den ausgewählten Zellen gelesenen Signale alle dieselben sind, und jeweils den genannten vorausgewählten Datenwert repräsentieren;

ii) die von den ausgewählten Zellen ausgelesenen Signale alle dieselben sind, und jeweils einen Datenwert repräsentieren, der von dem genannten vorausgewählten Datenwert verschieden ist;

iii) beziehungsweise die von den ausgewählten Zellen ausgelesenen Signale nicht alle dieselben sind.

2. Vorrichtung nach Anspruch 1, bei der die Transistoren des ersten Satzes (Q$_1$—Q$_4$) parallel zwischen einer ersten Energieversorgungsleitung (V$_{cc}$) und einem Ausgangspunkt (P$_1$) verbunden sind, und die Transistoren (Q$_5$—Q$_8$) des zweiten Satzes parallel zwischen dem genannten Ausgangspunkt (P$_1$) und einem weiteren Schaltungspunkt verbunden sind, wobei der genannte Ausgangspunkt (P$_1$) als Ausgangsanschlußeinrichtung dient.

3. Vorrichtung nach Anspruch 2, bei der die Lesetestschaltung (10) einen dritten Transistor (Q$_9$) umfaßt, der zwischen dem genannten weiteren Schaltungspunkt und einer zweiten Energieversorgungsleitung verbunden ist und eine Steuerelektrode hat, deren Potential von einem ersten Wert, einem solchen um den dritten Transistor nichtleitend zu machen, auf einen zweiten derartigen Wert schaltet, einem solchen um den dritten Transistor leitend zu machen, wenn die Lesetestschaltung (10) in Betrieb gesetzt werden soll.

4. Vorrichtung nach Anspruch 2 oder 3, bei der die genannte Lesetestschaltung (10) ferner einer Vielzahl von Widerständen (R$_1$ bis R$_8$) umfaßt, die in Reihe individuell mit entsprechenden Transistoren der ersten und zweiten Sätze (Q$_1$—Q$_8$) verbunden sind.

5. Vorrichtung nach Anspruch 1, bei der die Transistoren des ersten Satzes in Reihe zwischen einer ersten Versorgungsleitung (V$_{cc}$) und einem ersten Ausgangspunkt (P$_4$) verbunden sind, und die Transistoren (Q$_{15}$—Q$_{18}$) des zweiten Satzes in Reihe zwischen der genannten ersten Energieversorgungsleitung (V$_{cc}$) und einem zweiten Ausgangspunkt (P$_5$) verbunden sind, die Lesetestschaltung (10) ferner erste und zweite Widerstände (R$_9$, R$_{10}$) umfaßt, die ersten und zweiten

Ausgangspunkte (P$_4$, P$_5$) mittels der genannten ersten beziehungsweise zweiten Widerstände mit einer zweiten Energieversorgungsleitung verbunden sind und als die genannten Ausgangsanschlußeinrichtungen dienen.

6. Vorrichtung nach einem der vorhergehenden Ansprüche, bei der die Schreibschaltung (6, 7) eine Blockauswahlschaltung (6) enthält, welche eine Vielzahl von Transfergatetransistoren (Q$_{21}$, Q$_{22}$; bis Q$_{27}$, Q$_{28}$) umfaßt, die individuell mit entsprechenden Datenbuspaaren (DB$_1$, $\overline{DB}_1$; bis DB$_4$, $\overline{DB}_4$) verbunden sind, um die Eingangsdaten zu empfangen und die genannten Eingangsdaten an die genannten Datenbuspaare zu übertragen; und eine Vielzahl von Decodern (D$_1$—D$_4$), die individuell mit entsprechenden Paaren von Transfergatetransistoren (Q$_{21}$, Q$_{22}$; bis Q$_{27}$, Q$_{28}$) an entsprechenden Steuerelektroden davon verbunden sind, um eines der genannten Datenbuspaare (DB$_1$, $\overline{DB}_1$, bis DB$_4$, $\overline{DB}_4$) auszuwählen; und Simultanschreibeinrichtungen (Q$_{35}$, R$_0$, P$_3$), die jeweils mit den genannten Decodern (D$_1$—D$_4$) verbunden und betreibbar sind, um zu bewirken, daß alle genannten Datenbuspaare simultan ausgewählt werden, um so zu erlauben, daß die genannten Eingangsdaten simultan in alle Speicherzellen eingeschrieben werden, welche durch die genannte Zellenauswahleinrichtungen (2, 3, 4, 5) ausgewählt sind.

**Revendications**

1. Dispositif de mémoire à semiconducteur incluant une matrice (1-1, . . ., 1-4) de cellules de mémoire (C$_{00}$, C$_{01}$, . . ., C$_{31,127}$) disposées en lignes et en colonnes, les lignes et les colonnes étant connectées respectivement avec des fils de bit (BC$_0$, BC$_1$, . . .) et des fils de mot (WL$_0$, WL$_1$, . . .);

des moyens de sélection de cellules (2, 3, 4, 5) pour sélectionner des cellules de mémoire de manière à les mettre en connexion avec un fil d'entrée/sortie pour la lecture et l'écriture de données;

des circuits d'écriture (6, 7) pour écrire des valeurs de données présélectionnées ("0", "1") dans chacune des cellules de mémoire sélectionnées; et

des circuits de contrôle de lecture (10) pouvant être mis en fonctionnement en fonction d'un groupe de signaux, reçus des cellules de mémoire sélectionnées pour une lecture, afin de fournir une réponse indicatrice de défaut si le groupé de signaux diffère d'un groupe voulu prodéterminé qui est approprié pour un fonctionnement normal voulu du dispositif;

caractérisé en ce que ce dispositif comprend un ensemble des matrices, une paire individuelle de fils de bit étant connectée à chaque ligne individuelle de chaque matrice, et comprend en outre un ensemble de paires de bus de données (DB$_1$, $\overline{DB}_1$, . . ., DB$_4$, $\overline{DB}_4$), ces paires étant connectées respectivement aux · matrices de cellules de mémoire et fournissant les fils d'entrée/sortie respectifs, les moyens de sélection de cellules pouvant être mis en fonctionnement pour sélectionner une paire de fils de bit dans chaque matrice de mémoire de manière à placer les fils de bit sélectionnés en connexion simultanée avec les bus de données correspondants respectifs, une cellule étant ainsi sélectionnée dans chacune des matrices;

et en ce que les circuits de contrôle de lecture comprennent:

un premier groupe de transistors ($Q_1$—$Q_4$; $Q_{11}$—$Q_{14}$) égaux en nombre aux paires de bus de données et comportant des électrodes de commande respectives connectées individuellement à des premiers bus de données ($DB_1$—$DB_4$) respectifs de ces paires;

un deuxième groupe de transistors ($Q_5$—$Q_8$; $Q_{15}$—$Q_{18}$) égaux en nombre aux paires de bus de données et comportant des électrodes de commande respectives connectées individuellement à des deuxièmes bus de données respectifs ($\overline{DB_1}$—$\overline{DB_4}$) de ces paires, les premier et deuxième groupes de transistors étant connectés à des moyens à bornes de sortie de telle manière que, après la mise en oeuvre des circuits d'écriture pour écrire une valeur de donnée présélectionnée ("0" ou "1") dans chacune des cellules de mémoire sélectionnées, trois états de sortie de contrôle possibles différents peuvent être produits, aux moyens à bornes de sortie, indiquant respectivement que:

i) les signaux lus dans les cellules sélectionnées sont tous les mêmes, chacun représentant la valeur de donnée présélectionnée;

ii) les signaux lus dans les cellules sélectionnées sont tous les mêmes, chacun représentant une valeur de donnée différente de la valeur de donnée présélectionnée;

iii) les signaux lus dans les cellules sélectionnées ne sont pas tous les mêmes.

2. Dispositif selon la revendication 1, dans lequel les transistors du premier groupe ($Q_1$—$Q_4$) sont connectés en parallèle entre un premier fil de tension d'alimentation ($V_{cc}$) et un point de sortie ($P_1$), et les transistors ($Q_5$—$Q_8$) du deuxième groupe sont connectés en parallèle entre le point de sortie ($P_1$) et un autre point de circuit, le point de sortie ($P_1$) servant de moyen à borne de sortie.

3. Dispositif selon la revendication 2, dans lequel les circuits de contrôle de lecture (10) comprennent un troisième transistor ($Q_9$) connecté entre l'autre point de circuit et un deuxième fil d'alimentation et comportant une électrode de commande dont le potentiel est changé à partir d'une première valeur, telle qu'elle rend non conducteur le troisième transistor, jusqu'à une deuxième valeur, telle qu'elle rend conducteur le troisième transistor, quand les circuits de contrôle de lecture (10) doivent être rendus actifs.

4. Dispositif selon l'une quelconque des revendications 2 et 3, dans lequel les circuits de contrôle de lecture (10) comprennent en outre un ensemble de résistances ($R_1$ à $R_8$) connectées en série individuellement avec des transistors respectifs des premier et deuxième groupes ($Q_1$—$Q_8$).

5. Dispositif selon la revendication 1, dans lequel les transistors du premier groupe sont connectés en série entre un premier fil de tension d'alimentation ($V_{cc}$) et un premier point de sortie ($P_4$), et les transistors ($Q_{15}$—$Q_{18}$) du deuxième groupe sont connectés en série entre le premier fil de tension d'alimentation ($V_{cc}$) et un deuxième point de sortie ($P_5$), les circuits de contrôle de lecture (10) comprenant en outre des première et deuxième résistances ($R_9$, $R_{10}$), les premier et deuxième points de sortie ($P_4$, $P_5$) étant connectés à un deuxième fil de tension d'alimentation au moyen des première et deuxième résistances respectivement et servant de moyens à bornes de sortie.

6. Dispositif selon l'une quelconque des revendications 1 à 5, dans lequel les circuits d'écriture (6, 7) incluent des circuits de sélection de bloc (6) qui comprennent un ensemble de transistors à grille de transfert ($Q_{21}$, $Q_{22}$; à $Q_{27}$, $Q_{28}$), connectés individuellement aux paires de bus de données respectives ($DB_1$, $\overline{DB_1}$; à $DB_4$, $\overline{DB_4}$) pour recevoir des données d'entrée et transférer les données d'entrée jusqu'aux paires de bus de données;

un ensemble de décodeurs ($D_1$—$D_4$), connectés individuellement aux paires respectives de transistors à grille de transfert ($Q_{21}$, $Q_{22}$; à $Q_{27}$, $Q_{28}$) par leurs électrodes de commande respectives, pour sélectionner une des paires de bus de données ($DB_1$, $\overline{DB_1}$; à $DB_4$, $\overline{DB_4}$);

des moyens d'écriture simultanée ($Q_{35}$, $R_0$, $P_3$), connectés à chacun des décodeurs ($D_1$—$D_4$), pouvant être mis en fonctionnement pour faire en sorte que l'ensemble des paires de bus de données soient sélectionnées simultanément de manière à permettre l'écriture simultanée des données d'entrée dans l'ensemble des cellules de mémoire sélectionnées par les moyens de sélection de cellules (2, 3, 4, 5).

# Fig. 1

# Fig. 2

# Fig. 3

# Fig. 4

## Fig. 5

# Fig. 6

Fig. 7

EP 0 055 129 B1

# Fig. 8

# Fig. 9